Europäisches Patentamt

European Patent Office

Office européen des brevets

(19)

(11) **EP 0 996 244 A2**

(12) **EUROPÄISCHE PATENTANMELDUNG**

(43) Veröffentlichungstag:
26.04.2000 Patentblatt 2000/17

(51) Int Cl.⁷: **H04B 15/00**, H02B 1/32

(21) Anmeldenummer: **99810733.8**

(22) Anmeldetag: **16.08.1999**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **23.10.1998 DE 19849020**

(71) Anmelder: **ABB RESEARCH LTD.**
**8050 Zürich (CH)**

(72) Erfinder:
• **Sabbattini, Bruno**
**5430 Wettingen (CH)**

• **Lehmann, Josef**
**79761 Waldshut (DE)**
• **Rudolf, Paul**
**5234 Villigen (CH)**

(74) Vertreter: **Clerc, Natalia et al**
**ABB Business Services Ltd,**
**Intellectual Property (SLE-I),**
**Haselstrasse 16/699**
**5401 Baden (CH)**

(54) **Vorrichtung und Verfahren zum Orten von Störstellen in elektrischen Verteilnetzen**

(57) Zur Ortung von Störquellen wird an einer Phase (2,3,4) oder am Kabelschirm (5) der Leitung eines elektrischen Verteilnetzes ein Sensor (1) angeordnet, der die Spannung (U(t)) und den Strom (I(t)) misst. Diese beiden Messignale werden zu einer Auswerteschaltung (6) geführt, wo sie gefiltert, in digitale Signale, Fouriertransformiert, korrigiert und sodann miteinander multipliert werden um das Leistungsspektrum bei Frequenzen oberhalb der Grundfrequenz zu ermitteln. Der Realteil des Leistungsspektrums entspricht dem Wirkleistungsfluss und erlaubt es, die Richtung festzustellen, aus welcher ein Störsignal kommt. Durch Messungen an verschiedenen Orten eines Verteilnetzes lassen sich durch dieses Verfahren Störquellen eruieren.

Fig. 1

**Beschreibung**

Technisches Gebiet

Die Erfindung betrifft ein Verfahren zum Orten von Störstellen in elektrischen Verteilnetzen sowie eine Vorrichtung zur Ausführung dieses Verfahrens gemäss Oberbegriff und unabhängigen Ansprüche.

Stand der Technik

Elektrische Verbraucher, insbesondere solche mit Phasenanschnittsteuerungen können erhebliche Störungen in elektrischen Verteilnetzen erzeugen, was zu unerwünschten Signalen sowohl auf der Niederspannung als auch auf der Mittelspannung führt. Diese Störungen können unter anderem die PLC-Datenkommunikation auf den Netzen beeinträchtigen und sind deshalb unerwünscht.

Darstellung der Erfindung

Es stellt sich deshalb die Aufgabe, ein Verfahren bzw. eine Vorrichtung der eingangs genannten Art bereitzustellen, die es ermöglichen, Störquellen in Verteilnetzen in möglichst einfacher Weise zu orten.

Diese Aufgabe wird vom Gegenstand der unabhängigen Ansprüche gelöst.

Es wird also an mindestens einem Ort im Verteilnetz, vorzugsweise an mehreren Orten, die Richtung des Leistungsflusses des bzw. der Störsignale bestimmt, indem die Spannung und der Strom auf der Störfrequenz gemessen werden. Die Spannung und der Strom können einerseits auf einer Phase des Netzes, aber auch auf einem Kabelschirm bestimmt werden. Letzteres hat den Vorteil, dass Probleme aufgrund einer hohen Spannung bei der Grundfrequenz entfallen.

Vorzugsweise wird aus dem gemessenen Verlauf von Strom und Spannung das Wirkleistungsspektrum bestimmt. Die Vorzeichen der Frequenzkomponenten des Wirkleistungsspektrums zeigen an, in welche Richtung die Störleistung fliesst.

Kurze Beschreibung der Zeichnungen

Weitere Vorteile, Anwendungen und Ausführungen der Erfindung ergeben sich aus den abhängigen Ansprüchen und aus der nun folgenden Beschreibung anhand der Figuren. Dabei zeigen:

Fig. 1 ein Blockdiagramm einer Vorrichtung zur Ausführung des erfindungsgemässen Verfahrens,
Fig. 2 ein Wirkleistungsspektrum und
Fig. 3 ein vermaschtes Verteilnetz mit einer Störquelle.

Weg zur Ausführung der Erfindung

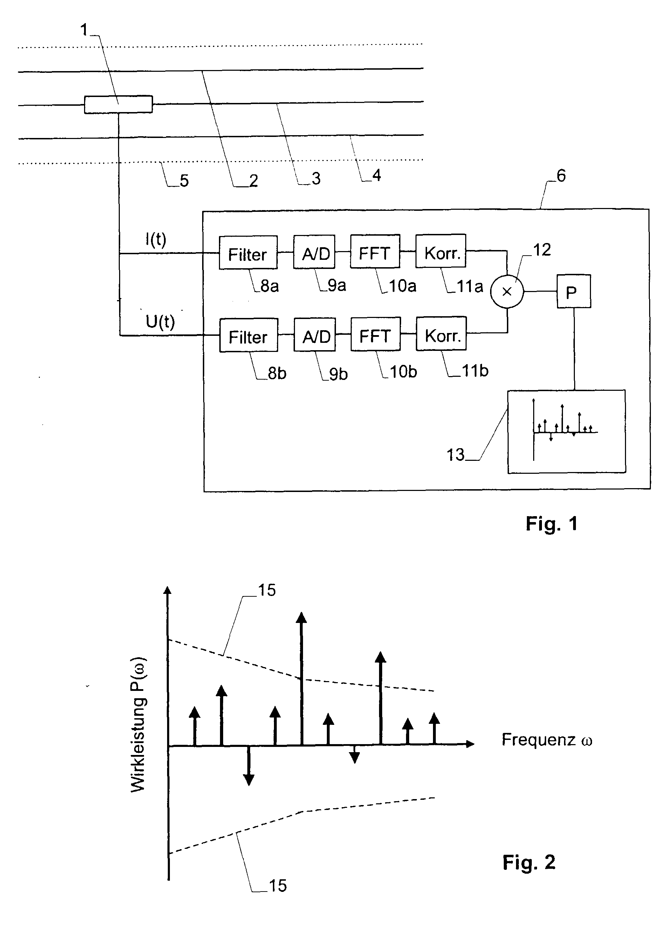

Das Verfahren gemäss vorliegender Erfindung basiert auf einer Messung des Leistungsflusses von Signalen gewisser Störfrequenzen. Fig. 1 zeigt eine mögliche Ausführung einer Vorrichtung zur Durchführung des Verfahrens.

Die Vorrichtung umfasst einen Sensor 1, der mit einer der Phasen 2, 3, 4 oder dem Kabelschirm 5 einer Mittel- oder Niederspannungsleitung eines Verteilnetzes verbunden werden kann. Der Sensor misst einerseits den momentanen Strom I(t), andererseits die momentane Spannung U(t) auf der Leitung.

Die beiden Messignale vom Sensor werden einer Auswerteschaltung 6 zugeführt und werden parallel durch verschiedene Aufbereitungsstufen geführt.

Ein Filter 8a, 8b entfernt Beiträge der Grundfrequenz (50/60 Hz) des Verteilnetzes sowie hohe Frequenzen, die in der späteren A/D-Wandlung zu " Aliasing"-Effekten führen würden.

Die gefilterten Signale werden Analog-Digital-Wandlern 9a, 9b zugeführt und gelangen von dort zu Stufe 10a, 10b, in welcher in einem gleitenden Datenfenster eine Fourier-Transformation durchgeführt wird. In einer Korrekturstufe 11a, 11b werden die Phasen der Fourier-Komponenten korrigiert, um durch die Messschaltung bedingte Verzögerungen bzw. Phasenverschiebungen auszugleichen. Die so berechneten komplexen Fourier-Komponenten $U(\omega)$, $I(\omega)$ beschreiben Real- und Imaginärteil bzw. Amplitude und Phase des Stroms U(t) und der Spannung I(t) in einem Bereich von ca. 150 Hz bis einige 100 kHz oder einige MHz.

In einer Multiplikationsstufe 12 werden die komplexen Fourier-Komponenten $U(\omega)$, $I(\omega)$ miteinander Multipliziert um das komplexe Leistungsspektrum $S(\omega)$ zu bilden:

$$S(\omega) = U(\omega) \times I(\omega)$$

Das Leistungsspektrum $S(\omega)$ besteht aus einem Realteil $P(\omega)$ und einem Imaginärteil $Q(\omega)$ :

$$S(\omega) = P(\omega) + j \cdot Q(\omega)$$

Dabei entspricht der Realteil $P(\omega)$ dem Wirkleistungsspektrum, $Q(\omega)$ dem Blindleistungsspektrum. Das Wirkleistungsspektrum $P(\omega)$ wird auf einer Anzeige 13 dargestellt.

Fig. 2 zeigt ein derartiges Wirkleistungsspektrum $P(\omega)$. In der Regel werden die stärksten Komponenten im Bereich der Harmonischen der Netzgrundfrequenz liegen, je nach Störquelle können jedoch auch ausserhalb der harmonischen Frequenzen Signale auftreten.

Aus dem Vorzeichen der Komponenten des Leistungsspektrums $P(\omega)$ kann ermittelt werden, in welche Richtung der Leistungsfluss bei der entsprechenden Frequenz stattfindet, d.h. man kann feststellen, ob die entsprechende Störquelle sich "links" oder "rechts" des Sensors 1 befindet.

In Fig. 2 sind obere und untere Limiten 15 für die Spektralkomponenten eingezeichnet. Komponenten, die innerhalb der Limiten 15 liegen, werden als unkritisch beurteilt und brauchen nicht beachtet zu werden. Spektralkomponenten die nicht innerhalb der Limite 15 liegen, sind nicht tolerierbar und die entsprechenden Störquellen müssen geortet werden.

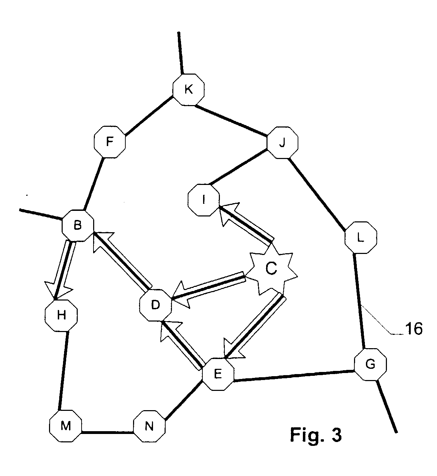

Die Ortung von Störquellen mit der Vorrichtung nach Fig. 1 ist in Fig. 3 dargestellt. Diese Figur zeigt eine vereinfachte Darstellung eines Verteilnetzes mit Trafostationen bzw. Umspannwerken B bis L und einem diese verbindenden Verteilnetz 16.

Wir gehen davon aus, dass z.B. an Punkt H auf der Leitung von B nach H auf einer Störfrequenz eine Störung festgestellt wird, d.h. der Wirkleistungsfluss $P(\omega)$ überschreitet zumindest für eine Frequenz die Limite 15. Aufgrund des Vorzeichens des Wirkleistungsflusses $P(\omega)$ bei der Störfrequenz kann festgestellt werden, dass die Störung von Punkt B her kommt.

Es werden deshalb bei Punkt B auf allen Leitungen Messungen durchgeführt und es wird festgestellt, dass einzig die Leitung von D die Limite 15 überschreitet und das der Wirkleistungsfluss $P(\omega)$ von D nach B gerichtet ist. Entsprechend wird eine Messung der Leitungen bei D durchgeführt. Aufgrund der maschenförmigen Topologie des Netzes nach Fig. 3 stellt man dort fest, dass Störungen sowohl von C als auch von E her kommen. Deshalb führt man nun Messungen bei E und C durch. Bei Punkt E zeigt es sich, dass der Wirkleistungsfluss auf der Störfrequenz von C her kommt, während bei C auf allen Leitungen ein von C weggerichteter Wirkleistungsfluss gemessen wird. Somit muss C die Störquelle sein.

Analog gestaltet sich die Suche im nicht vermaschten, sternförmig betriebenen Netz, wobei hier im Gegensatz zum vermaschten Netz keine Zweideutigkeiten auftreten können.

Im allgemeinen erlaubt es das vorliegende Verfahren, für jeden Punkt im Netz eine Wirkleistungsfluss-Bilanz zu erstellen. Auf diese Weise kann erkannt werden, wieviel Störleistung am jeweiligen Punkt erzeugt wird.

Wie eingangs erwähnt, kann der Sensor 1 direkt an einer Phase 2, 3, 4 der jeweiligen Leitung angeschlossen werden, was eine quantitative Messung des Wirkleistungsflusses erlaubt. Eine solche Messung ist jedoch aufwendig, da die hohe Spannung der Grundfrequenz hohe Anforderungen an die Isolation des Sensors 1 stellt. Um dieses Problem zu vermeiden, kann der Sensor 1 bei abgeschirmten Leitungen auch die Spannung und den Strom im Kabelschirm 5 messen. Aufgrund induktiver und kapazitiver Kopplungen zwischen den Phasen und dem Kabelschirm wird in der Regel auch dort noch ein ausreichend starkes und phasenrichtiges Signal vorhanden sein, um zumindest eine qualitative Messung des Wirkleistungsflusses durchzuführen.

Es ist auch denkbar, z.B. den Strom in einer Phase und die Spannung im Kabelschirm zu messen oder umgekehrt.

Bezugszeichen:

    1: Sensor
    2, 3, 4: Phasen
    5: Kabelschirm
    6: Auswerteschaltung
    8a, 8b: Filter
    9a, 9b: A/D-Wandler
    10a, 10b: FFT-Stufe
    11a, 11b: Korrekturstufe
    12: Multiplikator
    13: Anzeige
    15: Limiten
    16: Verteilnetz
    B - L: Trafostationen bzw. Umspannwerke
    I(t): Spannungsverlauf
    $P(\omega)$: Wirkleistungsspektrum bzw. -fluss
    $Q(\omega)$: Blindleistungsspekturm
    $S(\omega)$: Leistungsspektrum
    U(t): Stromverlauf

**Patentansprüche**

1.    Verfahren zum Orten von Störquellen in elektrischen Verteilnetzen, dadurch gekennzeichnet, dass an mindestens einem Ort im Verteilnetz durch Messung von Strom (I(t)) und Spannung (U(t)) auf mindestens einer Störfrequenz die Richtung des Wirkleistungsflusses ($P(\omega)$) eines Störsignals ermittelt wird.

2.    Verfahren nach Anspruch 1, dadurch gekennzeichnet, dass der Strom und/oder die Spannung auf mindestens einer Phase (2, 3, 4) des Verteilnetzes gemessen werden.

3.    Verfahren nach einem der vorangehenden Ansprüche, dadurch gekennzeichnet, dass der Strom und/oder die Spannung auf einem Kabelschirm (5) des Verteilnetzes gemessen werden.

4.    Verfahren nach einem der Ansprüche 2 oder 3, dadurch gekennzeichnet, dass der Strom auf dem Kabelschirm (5) und die Spannung auf der Phase (2, 3, 4) oder der Strom auf der Phase (2, 3, 4) und die Spannung auf dem Kabelschirm (5) gemessen werden.

**5.** Verfahren nach einem der vorangehenden Ansprüche, dadurch gekennzeichnet, dass der Wirkleistungsfluss (P($\omega$)) an mehreren Orten im Verteilnetz ermittelt wird, wobei aus dem Vorzeichen des Wirkleistungsflusses (P($\omega$))an den mehreren Orten die Störquelle geortet wird.

**6.** Verfahren nach einem der vorangehenden Ansprüche, dadurch gekennzeichnet, dass die Störfrequenz eine Frequenz oberhalb der Grundfrequenz des Verteilnetzes ist.

**7.** Verfahren nach einem der vorangehenden Ansprüche, dadurch gekennzeichnet, dass das Fourierspektrum der Spannung und des Stroms berechnet wird und zur Ermittlung des Wirkleistungsflusses (P($\omega$)) aus den Fourier-komponenten die Komponenten des Wirkleistungsspektrums errechnet wird, wobei aus den Vorzeichen der Komponenten des Wirkleistungsspektrums die Richtung des Leistungsflusses ermittelt wird.

**8.** Vorrichtung zur Durchführung des Verfahrens nach einem der vorangehenden Ansprüche, dadurch gekennzeichnet, dass sie Mittel (1, 6) zur Messung der Spannung und des Stroms und der Phasenverschiebung zwischen der Spannung und dem Strom bei mindestens einer Frequenz oberhalb der Grundfrequenz des Verteilnetzes aufweist.

Fig. 1

Fig. 2

Fig. 3